# EUROPEAN PATENT APPLICATION

(11) **EP 4 455 608 A1**
(43) Date of publication of application: **30.10.2024**
(21) Application number: 22911315.4
(22) Date of filing: 21.12.2022
(51) Int. Cl.: G01C 19/64, G02B 6/12, G02B 6/125

(54) **OPTICAL CIRCUIT, AND OPTICAL CIRCUIT DEVICE, SENSOR, AND MOVING BODY EMPLOYING SAME**

(30) Priority: 24.12.2021 JP 2021211659
(71) Applicant: Nichia Corporation, Anan-shi, Tokushima 774-8601 (JP)
(72) Inventor: OKADA, Masanori, Anan-shi, Tokushima 774-8601 (JP)
(74) Representative: Betten & Resch
(86) International application number: PCT/JP2022/047235
(87) International publication number: WO 2023/120613

(57) **Abstract**

An optical circuit capable of reducing a frequency variation of a light source caused by rotation is provided. The optical circuit includes a substrate, a laser light source formed on the substrate and including a first annular optical waveguide and a second annular optical waveguide that shares a part thereof with the first annular optical waveguide at one location, a first optical waveguide located on the substrate at a position separated from the laser light source and optically coupled to the laser light source, and a resonator optically coupled to the first optical waveguide.

## Description

### TECHNICAL FIELD

The present disclosure relates to optical circuits, and optical circuit devices, sensors, and moving bodies employing the same.

### BACKGROUND ART

A gyro sensor is used to measure an orientation and an angular velocity of a body. The gyro sensor is widely used not only in a moving body, such as an automobile or an aircraft, but also in an electronic device, such as a smartphone, a compact camera, or the like. Among gyro sensors, an optical gyro sensor uses the Sagnac effect. The Sagnac effect is a phenomenon in which an optical path length varies depending on a propagation direction of light when the optical path is rotated. By observing an interference of lights propagating through the optical path in mutually opposite directions, a rotation angle, that is, the angular velocity can be detected.

A proposed ring laser gyro has a Faraday rotator disposed in a circuit including a first optical path and a second optical path that are annular (refer to Patent Document 1, for example). In the Patent Document 1, a gain medium, such as an optical amplifier, a laser light source, or the like, is connected to an intermediate part of the circuit, and a connection state of the first optical path and the second optical path is switched in order to calibrate a frequency fluctuation of the Faraday rotator.

### PRIOR ART DOCUMENTS

### PATENT DOCUMENTS

Patent Document 1: Japanese Laid-Open Patent Publication No. 2010-230476

### DISCLOSURE OF THE INVENTION

### PROBLEM TO BE SOLVED BY THE INVENTION

A ring shaped light source may be used when forming an optical waveguide type light source on a substrate. For example, in sensor applications to measure the angular velocity, angular acceleration, or acceleration, the ring shaped light source itself is sensitive to rotation and is subject to a frequency variation caused by the rotation. One object of the present disclosure is to provide an optical circuit capable of reducing the frequency variation of the light source caused by the rotation.

### MEANS OF SOLVING THE PROBLEM

In one embodiment, an optical circuit includes:
a substrate;
a laser light source formed on the substrate and including a first annular optical waveguide and a second annular optical waveguide that shares a part thereof with the first annular optical waveguide at one location;
a first optical waveguide located on the substrate at a position separated from the laser light source and optically coupled to the laser light source; and
a resonator optically coupled to the first optical waveguide.

### EFFECTS OF THE INVENTION

It is possible to provide an optical circuit capable of reducing a frequency variation of the light source caused by rotation.

### BRIEF DESCRIPTION OF THE DRAWINGS

[FIG. 1] FIG. 1 is a schematic diagram of an optical circuit according to a first embodiment.
[FIG. 2A] FIG. 2A is a diagram illustrating a configuration example of a laser light source.
[FIG. 2B] FIG. 2B is a diagram illustrating another configuration example of the laser light source.
[FIG. 3] FIG. 3 is a top view of a vicinity of the laser light source of the optical circuit of FIG. 1.
[FIG. 4] FIG. 4 is a cross sectional view along a line A-A in FIG. 3.
[FIG. 5] FIG. 5 is a schematic diagram illustrating a combination of the optical circuit and an electric circuit for control.
[FIG. 6] FIG. 6 is a block diagram illustrating an operation of an optical circuit device.
[FIG. 7] FIG. 7 is a block diagram illustrating a configuration example of a frequency control.
[FIG. 8] FIG. 8 is a diagram illustrating a signal waveform obtained by a PDH technique.
[FIG. 9] FIG. 9 is a schematic diagram of the optical circuit according to a second embodiment.
[FIG. 10] FIG. 10 is a schematic diagram illustrating a combination of the optical circuit of FIG. 9 and the electric circuit for control.
[FIG. 11] FIG. 11 is a block diagram illustrating a phase control and an intensity control of the optical circuit of FIG. 9.
[FIG. 12] FIG. 12 is a block diagram illustrating an application example of the optical circuit according to the embodiment to a sensor.
[FIG. 13] FIG. 13 is a schematic view illustrating an application example to a moving body.

### MODE OF CARRYING OUT THE INVENTION

Hereinafter, embodiments for implementing the present disclosure will be described with reference to the drawings. The following description is intended to embody the technical idea of the present disclosure, and the present disclosure is not limited to that of the following description unless otherwise indicated.

In the drawings, members having the same functions may be designated by the same reference numerals. By taking into consideration the ease of explaining or understanding the main points, the embodiments may be illustrated separately for the sake of convenience, but partial replacement or combination of configurations illustrated in different embodiments or exemplary implementations is possible. In the latter embodiments, matters different from the former embodiments will mainly be described. Further, the description of matters common among the embodiments may be omitted. The size, positional relationships, or the like of the members illustrated in the drawings may be exaggerated for the clarity of the description.

### <First Embodiment>

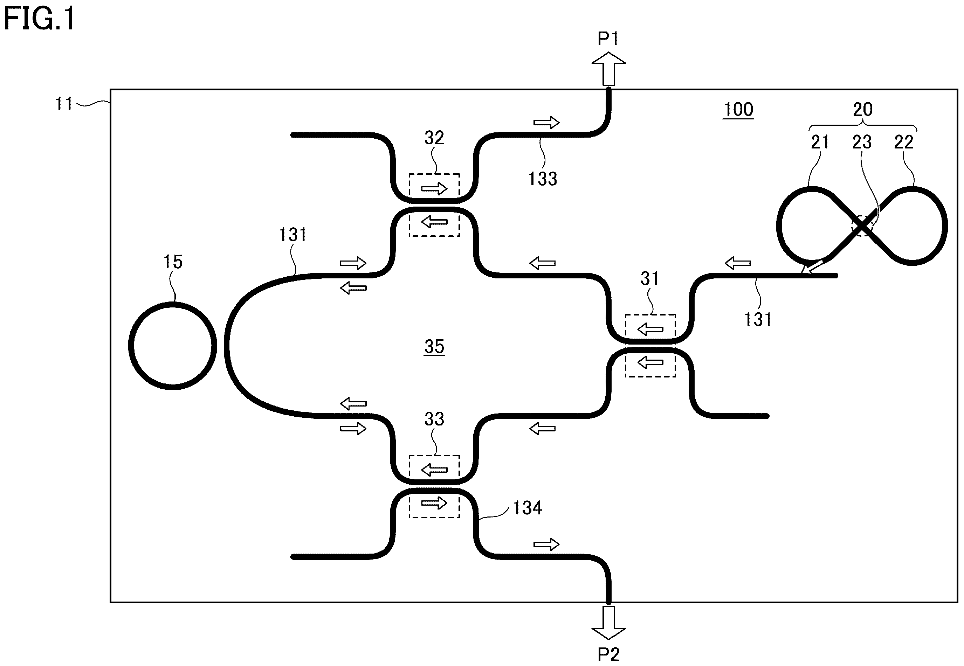

FIG. 1 is a schematic diagram of an optical circuit 100 according to a first embodiment. The optical circuit 100 includes a substrate 11, a laser light source 20 formed on the substrate 11, a first optical waveguide 131 located on the substrate 11 at a position separated from the laser light source 20 and optically coupled to the laser light source 20, and a resonator 15 optically coupled to the first optical waveguide 131. The laser light source 20 includes a first annular optical waveguide 21 and a second annular optical waveguide 22 that shares a part thereof with the first annular optical waveguide 21 at one location.

By connecting the first annular optical waveguide 21 to the second annular optical waveguide 22 so as to intersect or share a part thereof, light can be made to circulate in opposite directions in the first annular optical waveguide 21 and the second annular optical waveguide 22 while the light generated from the laser light source 20 makes one orbit. Hence, it is possible to reduce a variation in an optical path length, that is, a frequency variation, that occurs in the laser light source 20 itself when the optical circuit 100 is subject to rotation from an outside. For example, for the light circulating in the laser light source 20 in one direction when the optical circuit 100 is subject to the rotation, in a case where the optical path length of the first annular optical waveguide 21 increases due to the Sagnac effect, the optical path length of the second annular optical waveguide 22 decreases due to the Sagnac effect. The optical path length per one orbit of the laser light source 20 is determined by taking into consideration an extension of the optical path experienced by the light passing through the first annular optical waveguide 21 and a reduction of the optical path experienced by the light passing through the second annular optical waveguide 22. Accordingly, an optical path length difference as a whole is small between the case where the optical circuit 100 is subject to the rotation and the case where the optical circuit 100 is not subject to the rotation. With this configuration, it is possible to reduce the frequency variation of the laser light source 20 caused by the rotation.

The term "shares a part" includes both (1) a state where the first annular optical waveguide 21 and the second annular optical waveguide 22 intersect each other, and (2) a state where a part of the first annular optical waveguide 21 and a part of the second annular optical waveguide 22 overlap each other. Accordingly, in the laser light source 20, the first annular optical waveguide 21 and the second annular optical waveguide 22 may intersect each other or partially overlap each other at a shared part 23. In FIG. 1, the shared part 23 is provided at one location.

In a case where the optical circuit 100 is applied to the measurement of the angular velocity or the angular acceleration of a gyro sensor or the like, a configuration in which the first annular optical waveguide 21 and the second annular optical waveguide 22 intersect at the shared part 23 is desirable. In other words, it is desirable that the first annular optical waveguide 21 and the second annular optical waveguide 22 do not form a closed optical path independently, and the first annular optical waveguide 21 and the second annular optical waveguide 22 form a single resonator as the laser light source 20. This is because the Sagnac effect caused by the laser light source 20 itself can be reduced. The first annular optical waveguide 21 and the second annular optical waveguide 22 are not limited to circular optical waveguides, as long as the first annular optical waveguide 21 and the second annular optical waveguide 22 have the annular shape.

In general, a magnitude of the variation in the optical path length due to the Sagnac effect is proportional to an area surrounded by the optical path. As described above, the magnitude of the variation in the optical path length for the light circulating in the laser light source 20 in one direction is determined by taking into consideration an increase or a decrease of the optical paths of the first annular optical waveguide 21 and the second annular optical waveguide 22. This consideration can be achieved by considering a difference between a first area of a region surrounded by the first annular optical waveguide and a second area of a region surrounded by the second annular optical waveguide 22. A ratio of the first area to the second area is appropriately designed to fall between 0.5:1 and 2:1, and preferably between 0.7:1 and 1.4:1, for example. Thus, because the difference between the first area and the second area is reduced, the Sagnac effect generated in the laser light source 20 can be reduced, and it is possible to reduce the frequency variation of the laser light source 20 caused by the rotation.

From a viewpoint of further reducing the Sagnac effect generated in the laser light source 20 itself, the first area of the region surrounded by the first annular optical waveguide 21 and the second area of the region surrounded by the second annular optical waveguide 22 are preferably equal to each other. In this case, because there is no difference between the first area and the second area, the Sagnac effect generated in the laser light source 20 can be canceled, and it is possible to reduce the frequency variation of the laser light source 20. The term "equal" used to describe the areas does not necessarily imply that the areas are exactly the same, and may include a tolerable manufacturing error. In a case where the ratio of the first area to the second area falls between 0.95:1.00 and 1.05:1.00, these areas are herein referred to as being "equal". As long as the first area and the second area are equal to each other, the shape of the region surrounded by the first annular optical waveguide 21 and the shape of the region surrounded by the second annular optical waveguide 22 may be the same or may be different. Planar shapes of the first annular optical waveguide 21 and the second annular optical waveguide 22 are preferably designed appropriately by taking into consideration the area of the region surrounded by the annular optical waveguide, a wavelength, a refractive index of the material, or the like.

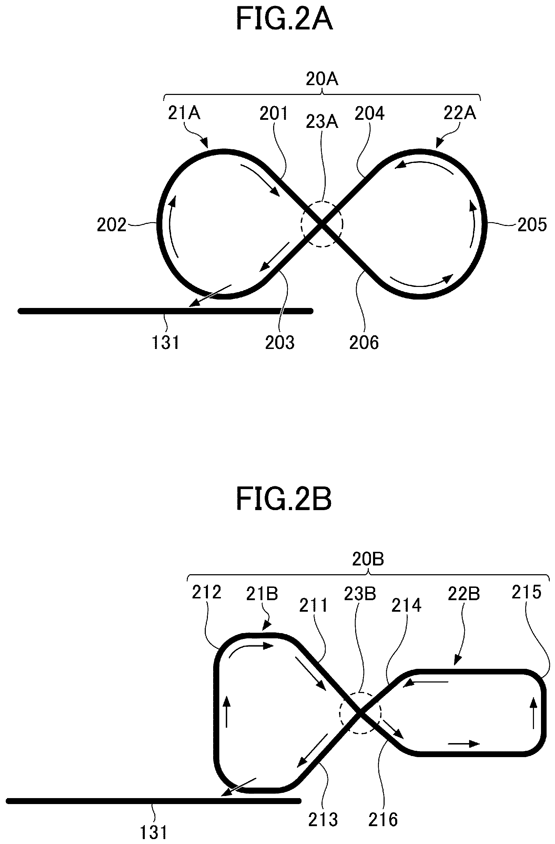

FIG. 2A and FIG. 2B illustrate configuration examples of the laser light source 20 as laser light sources 20A and 20B, respectively. In the laser light source 20A of FIG. 2A, a first annular optical waveguide 21A and a second annular optical waveguide 22A share a part thereof at a shared part 23A at one location. A first area of a region surrounded by the first annular optical waveguide 21A is equal to a second area of a region surrounded by the second annular optical waveguide 22A. A length of the shared part 23A is designed so that an optical loss, caused by the light circulating one of the annular optical waveguides not propagating through the other of the annular optical waveguides, is negligible or wall within a tolerable range. In other words, the shared part 23A is designed so that the light propagating from one of the annular optical waveguides to the other of the annular optical waveguides becomes dominant.

For example, the light propagating clockwise through the first annular optical waveguide 21A passes through the shared part 23A and propagates counterclockwise through the second annular optical waveguide 22A. Thus, the Sagnac effect of the laser light source 20A itself caused by the rotation is canceled, and it is possible to reduce the frequency variation of the laser light source 20A. The light propagating from the second annular optical waveguide 22A to the first annular optical waveguide 21A through the shared part 23A is coupled to the first optical waveguide 131 and propagates through the first optical waveguide 131.

As illustrated in the FIG. 2A, the first annular optical waveguide 21A includes a first linear waveguide 201 and a second linear waveguide 203. In addition, the second annular optical waveguide 22A includes a third linear waveguide 204 and a fourth linear waveguide 206. The first linear waveguide 201 is connected to the fourth linear waveguide 206. Further, the second linear waveguide 203 is connected to the third linear waveguide 204. A waveguide part formed by the first linear waveguide 201 and the fourth linear waveguide 206, and a waveguide part formed by the second linear waveguide 203 and the third linear waveguide 204 intersect at one location to form a shared part 23A.

An angle formed by the first linear waveguide 201 and the third linear waveguide 204 may be 30 degrees or greater and 150 degrees or less, preferably 60 degrees or greater and 120 degrees or less, and more preferably 90 degrees, for example. An angle formed by the fourth linear waveguide 206 and the second linear waveguide 203 may be 30 degrees or greater and 150 degrees or less, preferably 60 degrees or greater and 120 degrees or less, and more preferably 90 degrees, for example. Thus, in the shared part 23A, the propagation direction of the light propagating through the first annular optical waveguide 21A and the second annular optical waveguide 22A is less likely to vary. In addition, the waveguide part formed by the first linear waveguide 201 and the fourth linear waveguide 206 and the waveguide part formed by the second linear waveguide 203 and the third linear waveguide 204 may intersect at one location so that an angle formed by the waveguide parts is 80 degrees or greater and 100 degrees or less, preferably 85 degrees or greater and 95 degrees or less, more preferably 89 degrees or greater and 91 degrees or less, and even more preferably 90 degrees. Thus, the propagation direction of the light is less likely to vary in the shared part 23A. The term "90 degrees" used to describe the angle may include a tolerable manufacturing error. For example, even if an angle is 89.9 degrees or greater and 90.1 degrees, this angle is referred to as being 90 degrees in the present specification.

The first annular optical waveguide 21A may further include one or more bent waveguides. FIG. 2A illustrates a case where a first bent waveguide 202 are included in the first annular optical waveguide 21A. For example, one end of the first bent waveguide 202 may be connected to the first linear waveguide 201, and the other end of the first bent waveguide 202 may be connected to the second linear waveguide 203. In addition, the second annular optical waveguide 22A may further include one or more bent waveguides. FIG. 2A illustrates a case where a second bent waveguide 205 is included in the second annular optical waveguide 22A. One end of the second bent waveguide 205 may be connected to the third linear waveguide 204, and the other end of the second bent waveguide 205 may be connected to the fourth linear waveguide 206.

The light circulating in the laser light source 20A illustrated in FIG. 2A in one direction propagates through the first bent waveguide 202, the first linear waveguide 201, the fourth linear waveguide 206, the second bent waveguide 205, the third linear waveguide 204, the second linear waveguide 203, and the first bent waveguide 202 in this order, and makes one orbit in the optical path.

A distance between the laser light source 20A and the first optical waveguide 131 is set to a length that enables the laser light generated by the laser light source 20A to be optically coupled to the first optical waveguide 131. Accordingly, a minimum distance between the laser light source 20A and the first optical waveguide 131 may be approximately a length corresponding to the wavelength of the light output from the laser light source 20A. A strength of the optical coupling is determined by the distance between the laser light source 20A and the first optical waveguide 131, a length of mutually adjacent parts thereof, an overlap between a guided mode of the laser light source 20A and a guided mode of the first optical waveguide 131, or the like. These parameters are designed according to an amount of light of the laser light to be optically coupled from the laser light source 20A to the first optical waveguide 131. The distance between the laser light source 20A and the first optical waveguide 131 may be set to 500 nm or less, 300 nm or less, 100 nm or less, or the like, for example. In addition, in the first annular optical waveguide 21A, a region facing the first optical waveguide 131 may be a linear waveguide. In this case, it is possible to achieve an efficient optical coupling because a length of the part of the waveguide contributing to the optical coupling can be increased.

The first optical waveguide 131 is closest to the first annular optical waveguide 21A at parts other than the shared part 23A. Hence, of the laser light generated by the laser light source 20A, the light circulating in one direction can be optically coupled to the first optical waveguide 131 at an arbitrary percentage. The minimum distance between the first optical waveguide 131 and the first annular optical waveguide 21A is shorter than a minimum distance between the first optical waveguide 131 and the second annular optical waveguide 22A, and further, the minimum distance between the first optical waveguide 131 and the first annular optical waveguide 21A is shorter than a minimum distance between the first optical waveguide 131 and a corner of the shared part 23A. For example, the first optical waveguide 131 may be optically coupled to the first annular optical waveguide 21A at the first bent waveguide 202, between the first bent waveguide 202 and the first linear waveguide 201, or between the first bent waveguide 202 and the second linear waveguide 203, of the first annular optical waveguide 21A. Alternatively, for example, the first optical waveguide 131 may be optically coupled to the first annular optical waveguide 21 at the first linear waveguide 201 other than the shared part 23A, or the second linear waveguide 203 other than the shared part 23A.

In the laser light source 20B of FIG. 2B, a polygon shaped first annular optical waveguide 21B and a polygon shaped second annular optical waveguide 22B intersect at one location to form a shared part 23B. A first area of the region surrounded by the first annular optical waveguide 21B is larger than a second area of a region surrounded by the second annular optical waveguide 22B, but a ratio of the first area to the second area is 2 or less. In the present specification, a shape obtained by performing a process, such as chamfering, beveling, or the like, is also referred to as a polygon shape. For example, as illustrated in FIG. 2B, each of the first annular optical waveguide 21B and the second annular optical waveguide 22B, surrounded by a plurality of linear waveguides and a plurality of bent waveguides, will be referred to as having a pentagon shape.

As illustrated in FIG. 2B, the first annular optical waveguide 21B includes a first linear waveguide 211 and a second linear waveguide 213. In addition, the second annular optical waveguide 22B includes a third linear waveguide 214 and a fourth linear waveguide 216. The first linear waveguide 211 is connected to the fourth linear waveguide 216. Further, the second linear waveguide 213 is connected to the third linear waveguide 214. A waveguide part including the first linear waveguide 211 and the fourth linear waveguide 216, and the waveguide part including the second linear waveguide 213 and the third linear waveguide 214 intersect at one location to form the shared part 23B. The first annular optical waveguide 21B may further include a waveguide 212 that connects the first linear waveguide 211 and the second linear waveguide 213. The second annular optical waveguide 22B may further include an optical waveguide 215 that connects the third linear waveguide 214 and the fourth linear waveguide 216. The waveguides 212 and 215 may include one or more linear waveguides and/or one or more bent waveguides.

For example, the light propagating clockwise through the first annular optical waveguide 21B passes through the shared part 23B where the two optical waveguides intersect, and propagates counterclockwise through the second annular optical waveguide 22B. Thus, the Sagnac effect of the laser light source 20B itself caused by the rotation is reduced, and it is possible to reduce the frequency variation of the laser light source 20B. The light propagating from the second annular optical waveguide 22B to the first annular optical waveguide 21B through the shared part 23B is coupled to the first optical waveguide 131 and propagates through the first optical waveguide 131.

The first optical waveguide 131 is closest to the first annular optical waveguide 21B at parts other than the shared part 23B. Hence, of the laser light generated by the laser light source 20B, the light circulating in one direction can be optically coupled to the first optical waveguide 131 at an arbitrary percentage. A minimum distance between the first optical waveguide 131 and the first annular optical waveguide 21B is shorter than a minimum distance between the first optical waveguide 131 and the second annular optical waveguide 22B, and further, the minimum distance between the first optical waveguide 131 and the first annular optical waveguide 21B is shorter than a minimum distance between the first optical waveguide 131 and a corner of the shared part 23B. For example, the first optical waveguide 131 may be optically coupled to the first annular optical waveguide 21B at a linear waveguide or a bent waveguide included in an optical waveguide connecting the first linear waveguide 211 and the second linear waveguide 212, of the first annular optical waveguide 21B. Alternatively, for example, the first optical waveguide 131 may be optically coupled to the first annular optical waveguide 21B at the first linear waveguide 211 other than the shared part 23B, or the second linear waveguide 213 other than the shared part 23B. In FIG. 2B, the first optical waveguides 131 faces the linear waveguide of the waveguide 212 in the first annular optical waveguide 21B.

Planar shapes of the first annular optical waveguide 21 and the second annular optical waveguide 22 are not limited to the examples illustrated in FIG. 1, FIG. 2A, and FIG. 2B. The planar shapes of the first annular optical waveguide 21 and the second annular optical waveguide 22 may be any shapes as long as the laser light can propagate from one annular optical waveguide to the other annular optical waveguide and circulate. For example, a circular, elliptical, or racetrack shaped annular optical waveguide and a polygon shaped annular optical waveguide may be selected, as appropriate, and the annular optical waveguides may share a part thereof at a shared part at one location.

Returning now to the description of FIG. 1, the optical circuit 100 includes optical couplers 31, 32, and 33 and the first optical waveguide 131 extending therebetween, provided between the laser light source 20 and the resonator 15. The optical coupler 31 is a coupler formed by a part of the first optical waveguide 131 and having a branching ratio of 50:50. The optical coupler 31 functions as a first optical branch that branches the light optically coupled from the laser light source 20 to the first optical waveguide 131 at the ratio of 50:50, and a waveguide segment 35 is connected to the first optical branch. The waveguide segment 35 includes the optical couplers 31, 32, and 33, the first optical waveguide 131 extending therebetween, and parts of the other optical waveguides 133 and 134.

The optical coupler 32 is a coupler formed by a part of the first optical waveguide 131 and a part of the other optical waveguide 133, having a branching ratio of 50:50. The optical coupler 33 is a coupler formed by a part of the first optical waveguide and a part of the other optical waveguide 134, having a branching ratio of 50:50. The optical couplers 31, 32, and 33 may be formed as directional couplers or Y-branched waveguides.

One of the branched lights branched at an intensity ratio of 50:50 by the optical coupler 31 passes through the waveguide segment 35 counterclockwise, couples to the resonator 15 thereby circulating in the resonator 15, and couples again to the waveguide segment 35. The light that is optically coupled from the resonator 15 to the waveguide segment 35 and propagates through the waveguide segment 35 counterclockwise is extracted to the optical waveguide 134 by the optical coupler 33 and is output from an output port P2. The other light branched by the optical coupler 31 passes through the waveguide segment 35 clockwise, circulates in the resonator 15, and couples again to the waveguide segment 35. The light that is optically coupled from the resonator 15 to the waveguide segment 35 and propagates through the waveguide segment 35 clockwise is extracted to the optical waveguide 133 by the optical coupler 32 and is output from an output port P1.

A resonance frequency of the resonator 15 is determined by a circumference and an effective refractive index of the resonator 15. The effective refractive index varies depending on a width of the optical waveguide forming the resonator 15, an ambient temperature, or the like. A distance between the resonator 15 and the waveguide segment 35 and a coupling length thereof are designed so that an optical coupling of a desired intensity can be obtained. For example, the optical waveguide of the resonator 15 has a width of 2 µm or less and a height of 1 µm or greater and 2 µm or less, and the distance between the resonator 15 and the first optical waveguide 131 is approximately 100 nm or greater and approximately 500 nm or less.

The resonator 15 may be a ring resonator formed by the same processes as the laser light source 20 and the waveguide segment 35. Alternatively, the resonator 15 may be a whispering gallery mode (WGM) resonator disposed to face an upper surface of the first optical waveguide 131 forming a part of the waveguide segment 35. For example, crystals of magnesium fluoride (MgF₂), calcium fluoride (CaF₂), lithium niobate (LiNbO₃), or the like can be used for the WGM resonator. These materials have a high transmittance and birefringence, and are excellent resonator materials.

When the optical circuit 100 is subject to rotation, the optical path lengths experienced by the lights propagating through the resonator 15 in mutually opposite directions vary according to the rotation angle or the angular velocity, and resonance frequencies of the light circulating clockwise in the resonator 15 and the light circulating counterclockwise in the resonator 15 vary. As a result, resonance frequencies ω_{ccw} and ω_{cw} of the resonator 15 output from the output ports P1 and P2 vary. The angular velocity can be calculated from a difference between the resonance frequencies of the two output lights. In this state, the Sagnac effect caused by the rotation of the laser light source 20 itself can be reduced by making the first annular optical waveguide 21 and the second annular optical waveguide 22 intersect at one location or partially share each other. Noise caused by the laser light source 20 can be reduced, and it is possible to improve a detection sensitivity of the angular velocity obtained from the output of the optical circuit 100.

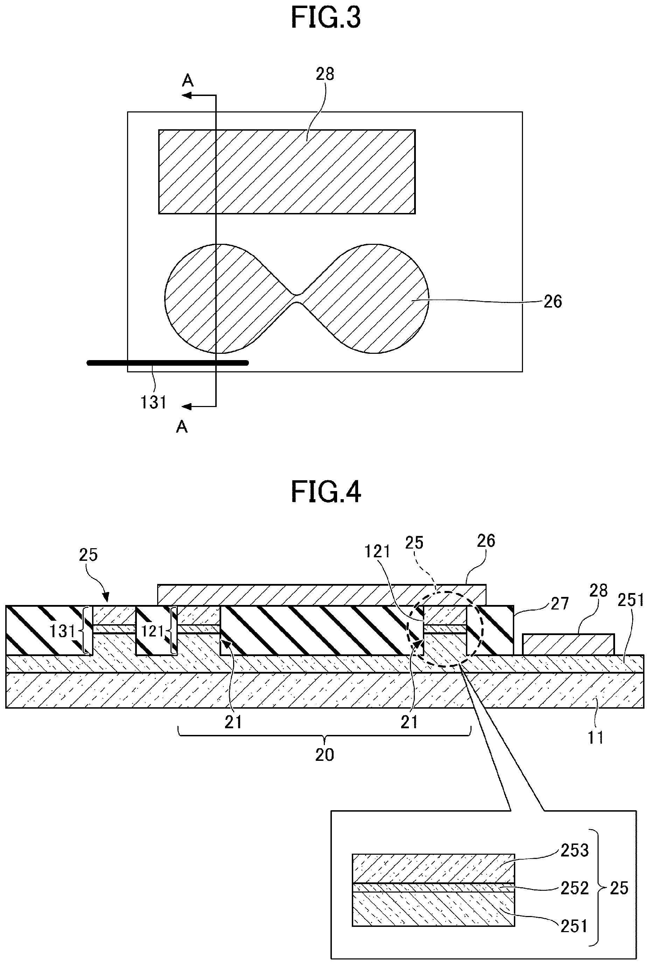

FIG. 3 is a top view of a vicinity of the laser light source 20 of the optical circuit 100, and FIG. 4 is a cross sectional view along a line A-A in FIG. 3. The optical circuit 100 is provided with electrodes 26 and 28 for injecting a current into the laser light source 20. The electrode 26 is formed to cover the first annular optical waveguide 21 and the second annular optical waveguide 22, and the electrode 28 is disposed in the vicinity of the laser light source 20.

The electrode 26 does not necessarily have to cover the entirety of the first annular optical waveguide 21 and the entire second annular optical waveguide 22, and may partially cover the first annular optical waveguide 21 and the second annular optical waveguide 22. The laser light source 20 is excited by the injection of the current, and laser light is generated inside the first annular optical waveguide 21 and the second annular optical waveguide 22. Materials that may be used for the electrodes 26 and 28 include Au, Pt, Ni, Ti, and ITO, for example.

As illustrated in FIG. 3 and FIG. 4, the first annular optical waveguide 21 and the second annular optical waveguide 22 of the laser light source 20 have a semiconductor layered structure 25 formed on the substrate 11. The semiconductor layered structure 25 includes a first semiconductor layer 251 including a first impurity of a first conductivity type, an active layer 252 provided on the first semiconductor layer 251, and a second semiconductor layer 253 including a second impurity of a second conductivity type provided on the active layer 252. The second semiconductor layer 253 is electrically connected to the electrode 26.

The first semiconductor layer 251, the active layer 252, and the second semiconductor layer 253 may be formed of a group III-V compound semiconductor, such as a GaN-based semiconductor, an InP-based semiconductor, a GaAs-based semiconductor, or the like. These compound semiconductor materials may be a two-element material, a three-element material, or a four-element material. In this case, a group III-V compound semiconductor substrate, such as a GaN substrate, a GaAs substrate, or the like, or a sapphire substrate may be used as the substrate 11.

The first semiconductor layer 251 is an n-side semiconductor layer, for example. The second semiconductor layer 253 is a p-side semiconductor layer, for example. The n-side semiconductor layer (the first semiconductor layer 251 in this example) includes an n-side cladding layer and an n-side optical guiding layer, and includes at least one or more n-type semiconductor layers. For example, Si or Ge can be used as the n-type impurity. A p-side semiconductor layer (the second semiconductor layer 253 in this example) includes a p-side optical waveguide layer and a p-side cladding layer, and includes at least one or more p-type semiconductor layers. For example, Mg can be used as the p-type impurity. The second semiconductor layer 253 may further include a p-side contact layer on the p-side cladding layer. In this case, the p-side contact layer is connected to the electrode 26.

The active layer 252 is a light emitting layer. The active layer 252 emits light having a peak wavelength in a range of 200 nm or greater and 1600 nm or less, for example. For example, the active layer has a multiple quantum well structure including a plurality of well layers and a plurality of barrier layers. In addition, the active layer 252 may output light having a peak wavelengths in a range of 200 nm or greater and 550 nm or less, for example. By using light having a relatively short wavelength, it is possible to increase a phase variation due to the Sagnac effect in the resonator 15, and improve the sensitivity of the sensor. The active layer 252 may output light having a peak wavelength in a range of 630 nm or greater and 1560 nm or less, for example. By using light having a relatively long wavelength, it is possible to increase the distance for optically coupling the laser light source 20 and the first optical waveguide 131, and the distance for optically coupling the first optical waveguide 131 and the resonator 15. This facilitates manufacturing of the optical circuit 100. The active layer 252 is interposed between an n-side cladding layer and a p-side cladding layer which have refractive indexes lower than a refractive index of the active layer 252 in a layered direction, and confines light therein. In a horizontal direction parallel to the substrate 11, the light is confined in the active layer 252 by an insulating layer 27 having a refractive index lower than the refractive index of the active layer 252. The insulating layer 27 may be formed of SiO2, SiN, Si3N4, SiON, or the like, for example.

The first annular optical waveguide 21 and the second annular optical waveguide 22 may include a ridge 121 formed by the semiconductor layered structure 25. The ridge 121 may be recessed to a bottom surface of the first semiconductor layer 251 or may be recessed to a part of the substrate 11, as long as light can be confined efficiently.

As an example, widths of the first annular optical waveguide 21 and the second annular optical waveguide 22 are 1 µm or less, and a height of the ridge 121 is 1 µm or greater and 2 µm or less. By reducing the waveguide width, the guided mode can be set to a single transverse mode. By increasing the height, confinement of the light can be enhanced, and a bending loss can be reduced. A radius of the region surrounded by the first annular optical waveguide 21 and a radius of the region surrounded by the second annular optical waveguide 22 are set between 5 µm or greater and 100 µm or less, for example.

The laser light source 20 can be manufactured by the following method, for example. First, the first semiconductor layer 251, the active layer 252, and the second semiconductor layer 253 are successively deposited on the substrate 11 by metal organic chemical vapor deposition (MOCVD) or physical vapor deposition (PVD). Examples of the PVD include sputtering and molecular beam epitaxy (MBE). Next, the first annular optical waveguide 21 and the second annular optical waveguide 22 including the ridge 121 can be formed by performing a process on the deposited semiconductor layers by photolithography and/or electron beam lithography.

The first optical waveguide 131, that is optically coupled to the laser light source 20, may be formed of the same material as the first annular optical waveguide 21 and the second annular optical waveguide 22 of the laser light source 20, or may be formed of a different material. In the example of FIG. 4, the first optical waveguide 131 has the semiconductor layered structure 25, similar to the first annular optical waveguide 21 and the second annular optical waveguide 22. That is, both the laser light source 20 and the first optical waveguide 131 are parts of the semiconductor layered structure 25. By forming the laser light source 20 and the first optical waveguide 131 from the common semiconductor layered structure 25, it is possible to align positions of the active layer 252 of the laser light source 20 and the core of the first optical waveguide 131, and the optical coupling can be facilitated. Similar to the laser light source 20, the first optical waveguide 131 can be formed by a continuous manufacturing process using photolithography and/or electron beam lithography.

In addition to the laser light source 20 and the first optical waveguide 131, the waveguide segment 35, the resonator 15, and the other optical waveguides 133 and 134 may also be formed of the semiconductor layered structure 25. By forming many parts of the optical circuit 100 from the semiconductor layered structure 25, it is possible to improve a robustness of the optical circuit 100. A configuration in which the circuit elements of the optical circuit 100 are formed on the single substrate 11 by the same semiconductor layered structure 25 has a higher robustness than a gyroscope including a movable part, such as a vibrating structure gyroscope using a micro electro-mechanical system (MEMS) .

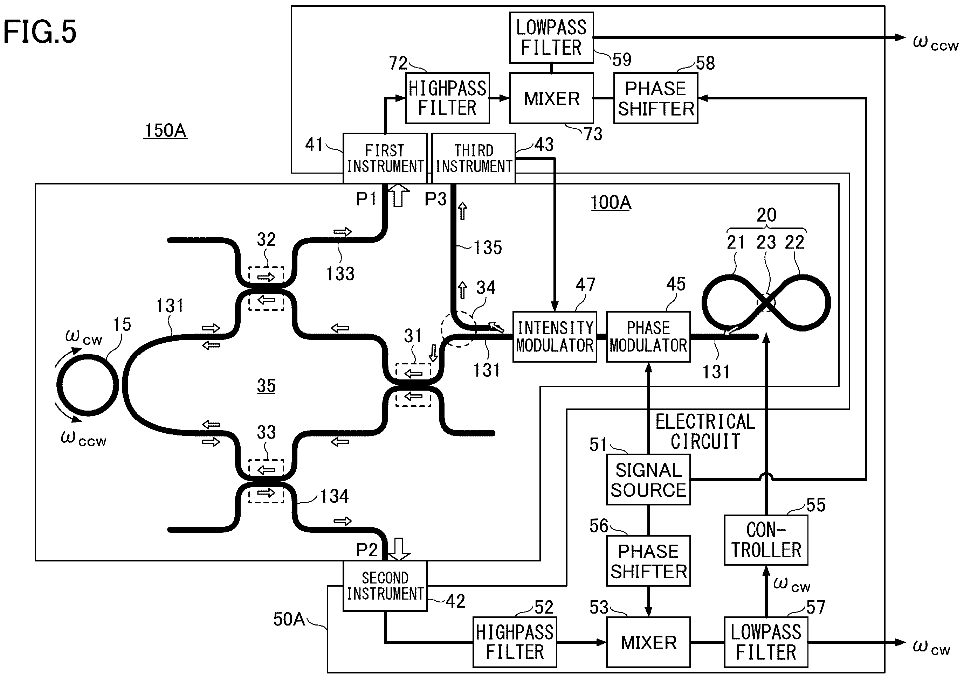

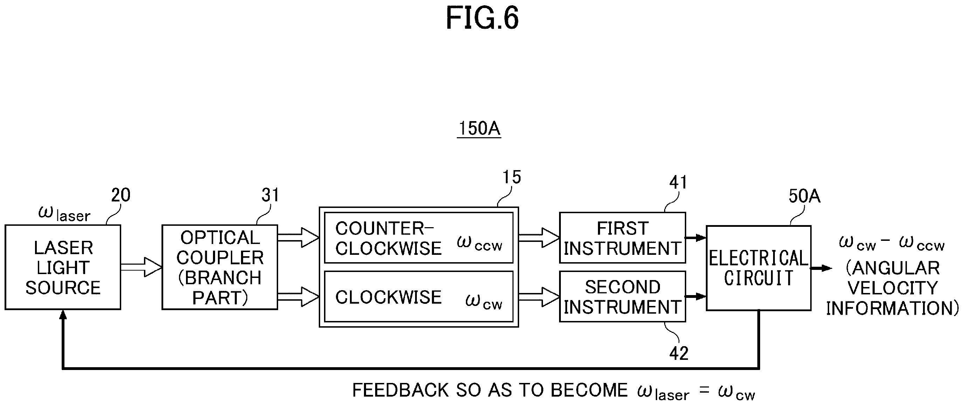

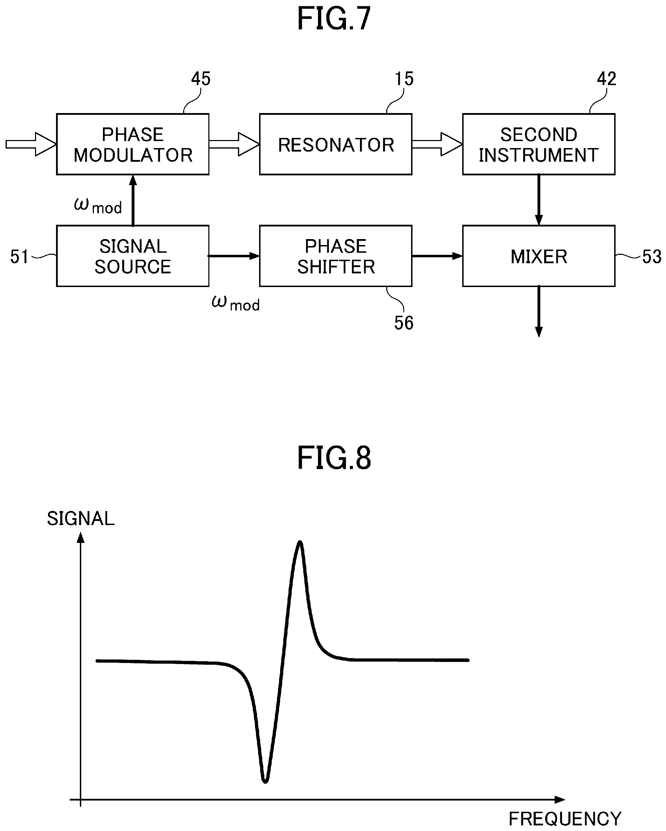

FIG. 5 is a schematic diagram of an optical circuit device 150A in which an electric circuit 50A for control is combined with an optical circuit 100A. FIG. 6 is a block diagram illustrating an operation of the optical circuit device 150A, and FIG. 7 is a block diagram illustrating a configuration example of a frequency control of the laser light source 20. The optical circuit 100A and the electric circuit 50A may be accommodated inside a single package to form an optical circuit device 150.

As illustrated in FIG. 5, the optical circuit 100A includes a phase modulator 45 that modulates a phase of the light output from the laser light source 20, and an intensity modulator 47 that adjusts an intensity of the light, in addition to the waveguide structure illustrated in FIG. 1. The phase modulator 45 applies an electric field, heat, acoustic vibration, or the like to the first optical waveguide 131, so as to vary the frequency of the propagating laser light by varying a refractive index of the first optical waveguide 131. The phase modulator 45 may be electrodes provided on a side of the first optical waveguide 131. A portion of a first optical waveguide 231 is disposed between two electrodes to form a single phase modulator 45. By passing a current from one electrode toward the other electrode, an electric field is applied to a part of the first optical waveguide 231, and the phase is modulated by an electro-optic effect. The intensity modulator 47 may be an electrode connected to the second semiconductor layer 253 of the first optical waveguide 131 and an electrode connected to the first semiconductor layer 251 provided on the side of the first optical waveguide 131, or may be a Mach-Zehnder interferometer. The intensity modulator 47 may function as a light intensity control device under a control of a controller 55 of the electric circuit 50A.

The optical circuit 100A also includes an optical coupler 34 between the waveguide segment 35 and the intensity modulator 47, and an output port P3 that extracts the light from the second optical waveguide 135 connected to the optical coupler 34. The optical coupler 34 is formed by a part of the first optical waveguide 131 and a part of the second optical waveguide 135, and is optically coupled. The optical coupler 34 may be a directional coupler or a Y-branched waveguide.

A first instrument 41 is connected to the output port P1, a second instrument 42 is connected to the output port P2, and a third instrument 43 is connected to the output port P3. Each of the first instrument 41, the second instrument 42, and the third instrument 43 may include a light detection element, such as a photodiode (PD) or the like, and an electric circuit component, such as a transimpedance amplifier (TIA), that converts a photocurrent output from the light detection element into a voltage signal. The light detection elements used in the first instrument 41, the second instrument 42, and the third instrument 43 may be incorporated into the optical circuit 100A, or may be externally connected to the optical circuit 100A by being connected to corresponding ports of the optical circuit 100A. Electric circuit components of the first instrument 41 and the second instrument 42 may be included in the electric circuit 50A.

As illustrated in FIG. 6, an output of the first instrument 41 may be used as a basis for calculating an angular velocity or an angular acceleration when the optical circuit 100A is applied to a gyro sensor. A difference between a resonance frequency ω_{ccw} of the resonator 15 measured by the first instrument 41 and extracted by the electric circuit 50A and a resonance frequency ω_{cw} of the resonator 15 measured by the second instrument 42 and extracted by the electric circuit 50A becomes angular velocity information of the rotation the optical circuit 100A is subject to.

An output of the second instrument 42 is used for frequency control of the laser light source 20, and is also used as a basis for calculating the angular velocity or the angular acceleration. Specifically, a frequency ωₗₐₛₑᵣ of the laser light source 20 is controlled to become the resonance frequency ω_{cw} included in the light that has passed through the resonator 15 and measured by the second instrument 42. The frequency ωₗₐₛₑᵣ of the laser light source 20 may be controlled to become the resonance frequency ω_{ccw} included in the light passed through the resonator 15 and measured by the first instrument 41. Accordingly, the frequency of the laser light source 20 matches either a first resonance frequency of the light that passes through the phase modulator 45 and circulates in a clockwise direction in the resonator 15 or a second resonance frequency of the light that passes through the phase modulator 45 and circulates in a counterclockwise direction in the resonator 15.

Returning to the description of FIG. 5, an output of the third instrument 43 is used for intensity adjustment of the laser light output from the laser light source 20, using the intensity modulator 47. The optical coupler 34 may be designed to branch light having an intensity of several percent of the propagating light for intensity monitoring. By controlling the amount of current applied to the intensity modulator 47 based on the output of the third instrument 43, the intensity of the laser light passing through the first optical waveguide 131 can be maintained constant. In a case where the intensity of the laser light passing through the first optical waveguide 131 is amplified by injecting a current into the intensity modulator 47, the intensity modulator 47 can function as an optical amplifier.

The electric circuit 50A includes electric circuit components of the second instrument 42, a signal source 51 that outputs a reference signal, a highpass filter 52, a mixer 53, a controller 55, a phase shifter 56, and a lowpass filter 57. In addition, the electric circuit 50A includes electric circuit components of the first instrument 41, a highpass filter 72, a mixer 73, a phase shifter 58, and a lowpass filter 59. The electric circuit 50A may include electric circuit components of the third instrument 43. The reference signal output from the signal source 51 is input to the phase modulator 45 of the optical circuit 100A and the mixers 53 and 73.

An error between the frequency of the laser light source 20 and the resonance frequency of the resonator 15 can be controlled by a method called the Pound-Drever Hall (PDH) technique. An outline of the PDH technique will be described with reference to FIG. 5 and FIG. 7. The laser light propagating through the optical circuit 100A is modulated by the phase modulator 45 according to the signal generated from the signal source 51 and having a reference frequency ω_{mod}. The signal measured by the second instrument 42 is demodulated by the highpass filter 52, the mixer 53, and the lowpass filter 57. A component that passes through the lowpass filter 57 is extracted as the resonance frequency ω_{cw} of the light that circulated clockwise in the resonator 15, and is input to the controller 55 as an error signal. The signal generated from the signal source 51 and having the reference frequency ω_{mod} is applied to the mixer 53. In this state, the signal having the reference frequency ω_{mod} passes through the phase shifter 56, and the phase is adjusted. The controller 55 feeds back the error signal to the laser light source 20, and the frequency of the laser light is stabilized at the resonance frequency of the resonator 15.

FIG. 8 illustrates an example of an output waveform of the mixer 53 or 73. By using the PDH technique, an asymmetric signal is obtained on the low frequency side and the high frequency side with the resonance frequency as the center as illustrated in FIG. 8, and a direction of the error from the resonance condition can be identified.

Referring back to the description of FIG. 5, in a case where the optical circuit device 150A is used for a sensor, the signal measured by the first instrument 41 is demodulated by the highpass filter 72, the mixer 73, and the lowpass filter 59. From the demodulated signal, a signal that passes through the lowpass filter 59 is extracted as a signal having the resonance frequency ω_{ccw} of the light circulated counterclockwise in the resonator. The reference frequency ω_{mod} generated by the signal source 51 is applied to the mixer 53. In this state, the signal having the reference frequency ω_{mod} passes through the phase shifter 58, and the phase is adjusted.

The output of the third instrument 43 for intensity control may be connected to an input of the controller 55 of the electric circuit 50A. In this case, the controller 55 may control an amount of current applied to the intensity modulator 47, based on a measurement result of the third instrument 43. The intensity control may be performed without using the third instrument 43 and the second optical waveguide 135. For example, the intensity modulator 47 may be controlled using a measurement result of the second instrument 42.

The output of the laser light source 20 may be output to the first optical waveguide 131 from the second annular optical waveguide 22 instead of from the first annular optical waveguide 21. The first optical waveguide 131 may be closest to one or both of the first annular optical waveguide 21 and the second annular optical waveguide 22, in order to extract the laser light. The first optical waveguide 131 is preferably closest to one of the first annular optical waveguide 21 and the second annular optical waveguide 22. In this case, it is possible to reduce unwanted interference in the first optical waveguide 131, and stabilize the power of the light propagating through the first optical waveguide 131.

In the optical circuit 100 of FIG. 1 and the optical circuit 100A of FIG. 5, the Sagnac effect caused by the laser light source 20 can be reduced, and the frequency of the laser light source 20 can be stabilized. In the case where the optical circuits 100 and the 100A are applied to a gyro sensor, noise caused by the laser light source 20 can be reduced, and the sensitivity of the angular velocity or angular acceleration information due to the difference in the resonance frequencies of the resonator 15 can be increased.

### <Second Embodiment>

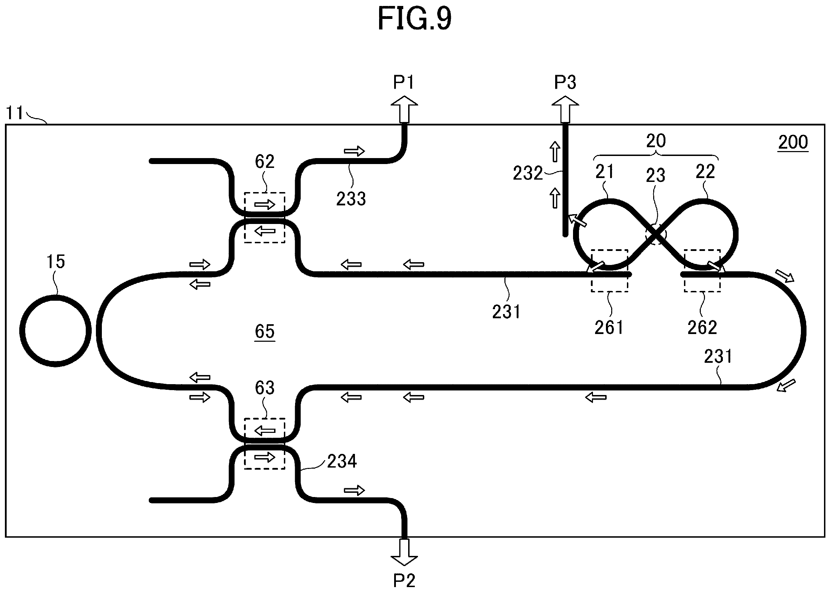

FIG. 9 is a schematic diagram of an optical circuit 200 according to a second embodiment. In the second embodiment, the laser light source 20 and the first optical waveguide 231 are optically coupled at two locations.

The optical circuit 200 includes the substrate 11, the laser light source 20 formed on the substrate 11, the first optical waveguide 231 located on the substrate 11 at a position separated from the laser light source 20 and optically coupled to the laser light source 20, and the resonator 15 optically coupled to the first optical waveguide 231. Similar to the first embodiment, the laser light source 20 includes the first annular optical waveguide 21, the second annular optical waveguide 22, and the shared part 23 where the first annular optical waveguide 21 and the second annular optical waveguide 22 intersect at one location or partially share each other. The waveguide structure and the electrode structure of the laser light source 20 are the same as the structures described with reference to FIG. 4.

The first optical waveguide 231 includes a first optical coupler 261 optically coupled to the first annular optical waveguide 21 of the laser light source 20, and a second optical coupler 262 optically coupled to the second annular optical waveguide 22. A ratio of a magnitude of the optical coupling of the first optical coupler 261 to a magnitude of the optical coupling of the second optical coupler 262 may be between 0.8:1 and 1.2:1. In addition, the ratio of the magnitude of optical coupling of the first optical coupler 261 to the magnitude of optical coupling of the second optical coupler 262 is preferably 1:1. Accordingly, it is possible to match powers of the lights propagating in mutually opposite directions in the resonator 15. For example, a minimum distance between the first annular optical waveguide 21 and the first optical waveguide 231 in the first optical coupler 261 and a minimum distance between the second annular optical waveguide 22 and the first optical waveguide 231 in the second optical coupler 262 are set to be the same. Alternatively, a length (coupling length) in an optical axis direction in which the first annular optical waveguide 21 and the first optical waveguide 231 are adjacent to each other in the first optical coupler 261 and a coupling length between the second annular optical waveguide 22 and the first optical waveguide 231 in the second optical coupler 262 are set to be the same. The coupling length between the first optical coupler 261 and the second optical coupler 262 is 1 µm or greater and 50 µm or less, and preferably 5 µm or greater and 20 µm or less, for example. The first optical waveguide 231 forms a part of the waveguide segment 65 that is open between the first optical coupler 261 and the second optical coupler 262.

The first optical waveguide 231 is optically coupled to the resonator 15 between the first optical coupler 261 and the second optical coupler 262. The optical coupler 62 is provided between the first optical coupler 261 of the first optical waveguide 231 and the resonator 15. The light from the second optical coupler 262 propagating clockwise through the first optical waveguide 231 and circulating in the resonator 15 is coupled to the optical waveguide 233 by the optical coupler 62, and is output from the output port P1. The optical coupler 63 is provided between the second optical coupler 262 of the first optical waveguide 231 and the resonator 15. The light from the first optical coupler 261 propagating counterclockwise through the first optical waveguide 231 and circulating in the resonator 15 is coupled to the optical waveguide 234 by the optical coupler 63, and is output from the output port P2.

The waveguide segment 65 is formed by the optical couplers 62 and 63, the first optical waveguide 231 connecting the optical couplers 62 and 63, and parts of the optical waveguides 233 and 234. The waveguide segment 65 is open between the first optical coupler 261 and the second optical coupler 262, and has an opening. Two end portions of the first optical waveguide 231 forming the opening of the waveguide segment 65 are preferably subjected to a process or coating. By extracting the light propagating to the end portion to the outside of the optical circuit, it is possible to reduce the light propagating in an opposite direction in the first optical waveguide 231. For example, the end portion may be a sloping surface or a periodic structure. Such a sloping surface or a periodic structure can be obtained by performing a process such as etching, for example. An antireflection film may be formed on the end portion.

The optical circuit 200 includes a second optical waveguide 232 disposed on the substrate 11 so as to optically couple to the laser light source 20. The second optical waveguide 232 is connected to the output port P3. As will be described later, the third port is used as a monitoring port for use in controlling the output intensity of the laser light source 20 constant. A monitored result is fed back to the laser light source 20, and the intensity of the monitored light is controlled to be constant.

The second optical waveguide 232 is disposed so that the optical coupling between the second optical waveguide 232 and the laser light source 20 becomes weaker than the optical coupling between the first optical waveguide 231 and the laser light source 20. In this case, most of the power of the light generated by the laser light source 20 can be distributed more to the first optical waveguide 231 than to the second optical waveguide 232, and a desired power can be introduced into the first optical waveguide 231 with a small amount of current. For example, the distance between the second optical waveguide 232 and the laser light source 20 is configured to be greater than the distance between the first optical waveguide 231 and the laser light source 20, or the coupling length between the second optical waveguide 232 and the laser light source 20 is configured to be smaller than the coupling length between the first optical waveguide 231 and the laser light source 20. In FIG. 9, the second optical waveguide 232 is optically coupled to the first annular optical waveguide 21 of the laser light source 20, but the second optical waveguide 232 may be disposed at a position so as to optically couple to the second annular optical waveguide 22.

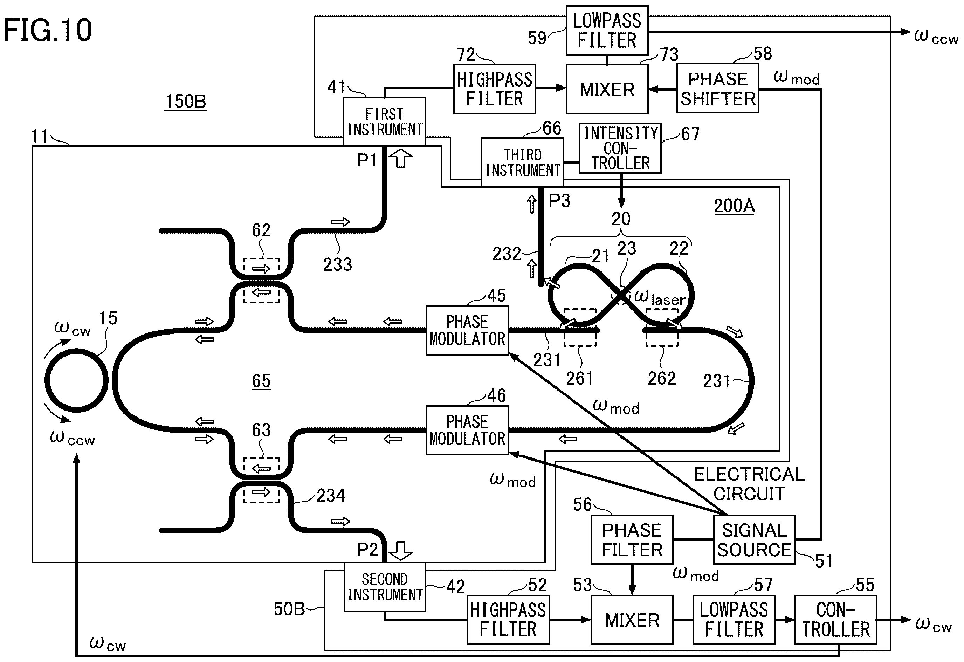

FIG. 10 is a schematic diagram of an optical circuit device 150B in which an electric circuit 50B for control is combined with an optical circuit 200A. The optical circuit 200A includes, in addition to the waveguide structure illustrated in FIG. 9, a phase modulator 45 that modulates the phase of the light from the laser light source 20 coupled to the first optical waveguide 231 by the first optical coupler 261, and a phase modulator 46 that modulates the phase of the light from the laser light source 20 coupled to the first optical waveguide 231 by the second optical coupler 262.

The phase modulator 45 is provided between the first optical coupler 261 and the resonator 15, and modulates the frequency of the laser light propagating counterclockwise through the first optical waveguide 231 by varying the refractive index of the first optical waveguide 231. The phase modulator 46 is provided between the second optical coupler 262 and the resonator 15, and modulates the frequency of the laser light propagating clockwise through the first optical waveguide 231 by varying the refractive index of the first optical waveguide 231. The phase modulators 45 and 46 have the same configuration as that of the first embodiment.

The first instrument 41 is connected to the output port P1, the second instrument 42 is connected to the output port P2, and the third instrument 66 is connected to the output port P3. Each of the first instrument 41, the second instrument 42, and the third instrument 66 may include a light detection element, such as a photodiode (PD) or the like, and an electric circuit component, such as a transimpedance amplifier (TIA), that converts a photocurrent output from the light detection element into a voltage signal.

The light detection elements used in the first instrument 41, the second instrument 42, and the third instrument 66 may be incorporated into the optical circuit 200A, or may be externally connected to the optical circuit 200A by being connected to corresponding ports of the optical circuit 200A.

The electric circuit 50B includes the signal source 51, the electric circuit components of the first instrument 41, the highpass filter 72, the mixer 73, the phase shifter 58, the lowpass filter 59, the electric circuit components of the second instrument 42, the highpass filter 52, the mixer 53, the phase shifter 56, the lowpass filter 57, the controller 55, the electric circuit components of the third instrument 66, and the intensity controller 67.

Similar to the first embodiment, the frequencies of the lights passing through the phase modulators 45 and 46 are modulated by the reference frequency ω_{mod} output from the signal source 51. The electric circuit 50B controls the error between the frequencies of the laser light source 20 and the resonator 15 by the PDH technique, similar to the first embodiment. However, the second embodiment differs from the first embodiment in that the resonance frequency of the resonator 15 is stabilized to the frequency of the laser light source 20. That is, the controller 55 feeds back the error signal between the frequency of the resonator 15 and the frequency of the laser light to the resonator 15, so that the resonance frequency of the resonator 15 is stabilized to the frequency of the laser light source 20.

The signal source 51 outputs reference signals having the reference frequency ω_{mod} to the phase modulator 45 and the mixer 53, and to the phase modulator 46 and the mixer 73. The four reference signals may be the same or different. If the frequency ω_{mod1} of the reference signals supplied to the phase modulator 45 and the mixer 53 are the same and the frequency ω_{mod2} of the reference signals supplied to the phase modulator 46 and the mixer 73 are the same, the frequencies ω_{mod1} and ω_{mod2} may be different.

The light that is phase modulated by the phase modulator 45 and resonates clockwise in the resonator 15 propagates counterclockwise through the first optical waveguide 231 and is measured by the second instrument 42. An output of a demodulated signal is used for controlling the resonance frequency of the resonator 15 and also used as a basis for calculating the angular velocity or angular acceleration when the optical circuit 200A is applied to a sensor. The resonance frequency ω_{cw} of the light circulating clockwise in the resonator 15 is stabilized to the frequency ωₗₐₛₑᵣ of the light output from the laser light source 20 to the first optical waveguide 231. The resonator 15 is provided with electrodes, and a signal output from the controller 55 is applied to the electrodes and used for controlling the resonance frequency. The resonance frequency can be controlled by utilizing the electro-optic effect, temperature, sound waves, or the like.

The light that is phase modulated by the phase modulator 46 and resonates counterclockwise in the resonator 15 propagates clockwise through the first optical waveguide 231 and is measured by the first instrument 41. An output of a demodulated signal is used as a basis for the calculating the angular velocity or angular acceleration when the optical circuit 200A is applied to a sensor.

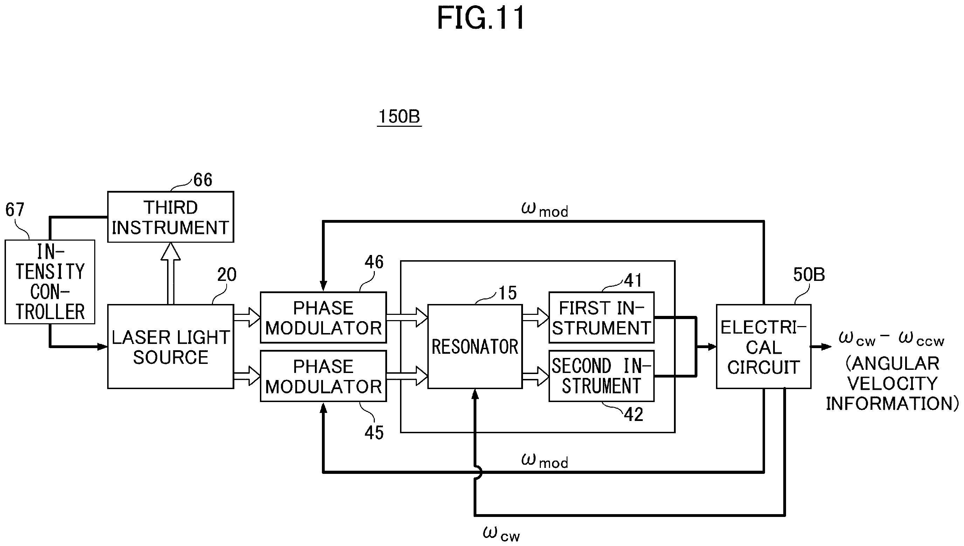

The third instrument 66 measures an intensity of the light guided through the second optical waveguide 232. The output of the third instrument 66 is supplied to the intensity controller 67. The intensity controller 67 performs a feedback control on the laser light source 20 so that the intensity of light measured by the third instrument 66 becomes constant. Hence, it is also possible to maintain a ratio of optical coupling between the first optical waveguide 231 and the laser light source 20 constant. In the configuration of FIG. 11, because the laser light intensity is monitored in an immediate vicinity of the laser light source 20, it is possible to improve the accuracy of the laser light intensity control. The intensity controller 67 is connected to the electrodes 26 and 28 described with reference to FIG. 4, for example, and adjusts the amount of current applied to the laser light source 20.

FIG. 11 is a block diagram illustrating a phase control and an intensity control of the optical circuit 200A. As described with reference to FIG. 9, the laser light output from the laser light source 20 is branched at the first optical coupler 261 and the second optical coupler 262 with an intensity ratio of 1:1, and the branched lights propagate through the first optical waveguide 231 in mutually opposite directions. The phase modulators 45 and 46 are provided between the laser light source 20 and the resonator 15.

As illustrated in FIG. 11, the light guided in the clockwise direction through the first optical waveguide 231 is modulated by the phase modulator 46, circulates in the resonator 15, and is detected by the photodetector of the first instrument 41. A detection result is input to the electric circuit 50B. The light guided in the counterclockwise direction through the first optical waveguide 231 is modulated by the phase modulator 45, circulates through the resonator 15, and is detected by the photodetector of the second instrument 42. A detection result is input to the electric circuit 50B. Similar to the first embodiment, the difference between the resonance frequencies ω_{cw} and ω_{ccw} of the resonator 15 extracted by the electric circuit 50B becomes the angular velocity information of the rotation the optical circuit 200A is subject to.

The reference signal having the reference frequency ω_{mod} is applied to phase modulators 45 and 46 from the electric circuit 50B. As described above, the frequency of the reference signal applied to the phase modulator 45 and the frequency of the reference signal applied to the phase modulator 46 may be the same or different.

The reference signals applied to the phase modulators 45 and 46 are used for controlling the resonance frequencies of the resonator 15. That is, the frequency of the laser light source 20 matches either a first resonance frequency of the light circulating in the resonator 15 in the clockwise direction or a second resonance frequency of the light circulating in the resonator 15 in the counterclockwise direction. In the example of FIG. 11, the resonance frequency ω_{cw} of the light circulating in the resonator 15 in the clockwise direction is controlled to approach the frequency ωₗₐₛₑᵣ of the laser light source 20. The resonance frequency ω_{ccw} of the resonator 15 may be controlled to approach the frequency ωₗₐₛₑᵣ of the laser light source 20.

During the intensity control, the light coupled from the laser light source 20 to the second optical waveguide 232 is detected by the third instrument 66, and the detection result is supplied to the intensity controller 67. The power of the laser light source 20 is controlled based on the output of the intensity controller 67. The light intensity of the laser light source 20 can be increased by increasing the injection current to the laser light source 20.

In the optical circuits 200 and 200A of the second embodiment, the Sagnac effect caused by the laser light source 20 is reduced by the waveguide structure having the first annular optical waveguides 21, the second annular optical waveguides 22, and the shared part 23 where the first annular optical waveguide 21 and the second annular optical waveguide 22 intersect at one location or partially share each other. In a case where the optical circuits 200 and 200A are applied to a sensor that measures the angular velocity or the angular acceleration, it is possible to reduce the noise caused by light source, and improve the detection sensitivity.

### <Application to Sensor>

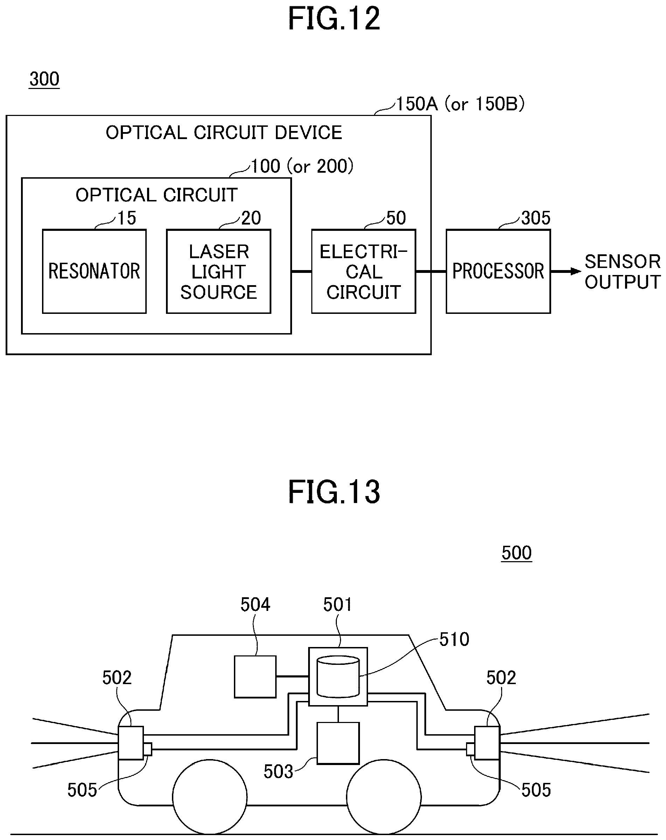

FIG. 12 is a block diagram illustrating an application example of the optical circuit according to the embodiment to a sensor. A sensor 300 includes the optical circuit 100 (or 200), the electric circuit 50, and a processor 305 that processes the output of the electric circuit 50. The optical circuit 100 (or 200) and the electric circuit 50 form the optical circuit device 150A (or 150B). The output of the optical circuit device 150A (or 150B) is connected to an input of the processor 305. More specifically, the electric circuit 50 outputs a signal generated based on the measurement result of the first instrument 41 and the measurement result of the second instrument 42 to the processor 305, and the processor 305 processes the signal input thereto. At least a part of the electric circuit 50 may be included in the processor 305. The output of the processor 305 becomes the sensor output.

The optical circuit may be the optical circuit 100 of the first embodiment or the optical circuit 200 of the second embodiment. The optical circuit 100 includes the optical circuit 100A combined with the phase modulator 45 and the intensity modulator 47 (refer to FIG. 5). The optical circuit 200 includes the optical circuit 200A combined with the phase modulators 45 and 46 (refer to FIG. 10).

The optical circuit 100 or 200 includes the laser light source 20 having the waveguide structure described above, and the resonator 15. The optical circuit 100 includes the waveguide segment 35 formed of the first optical waveguide 131 that guides the laser lights in mutually opposite directions, in addition to the laser light source 20 and the resonator 15. The optical circuit 200 includes the waveguide segment 65 formed of the first optical waveguide 231 that guides the laser lights in mutually opposite directions.

The electric circuit 50 may be the electric circuit 50A of the first embodiment or the electric circuit 50B of the second embodiment. The electric circuit 50 may include the electric components of the first instrument 41 that detects a first output light circulating in the resonator 15 in a first direction, and the electric components of the second instrument 42 that detects a second output light circulating in the resonator 15 in a second direction opposite to the first direction. A detection result of the first output light and a detection result of the second output light are input from the electric circuit 50 to the processor 305 as detection signals of the resonance frequencies ω_{cw} and ω_{ccw}. The processor 305 processes the detection signals of the first output light and the second output light, and calculates and outputs the angular velocity, the angular acceleration, or the like.

The laser light source 20 causes the laser lights to circulate in mutually opposite directions, thereby reducing the Sagnac effect caused by the laser light source 20 when the laser light source 20 is subject to rotation. Accordingly, the sensor 300 can reduce noise, and detect rotation information, such as the angular velocity, the angular acceleration, or the like with a high sensitivity. In a case where optical circuit elements, such as the laser light source 20, the first optical waveguides 131 and 231 forming the waveguide segments, or the like are integrated on the substrate 11 by the semiconductor layered structure 25, the robustness of the optical circuit becomes high. If the resonator 15 is also formed of the semiconductor layered structure 25 and is integrated on the substrate 11, the robustness of the optical circuit can further be improved. Further, in a case where a WGM resonator is used, the WGM resonator and the substrate 11 may be interposed between plates and screwed, or may be interposed between clamps and fixed.

The optical circuits 100, 100A, 200, and 200A, the optical circuit devices 150A and 150B, or the sensor 300 of the embodiments can be used in a driving support system of a moving body, for example. Because the elements of the optical circuit are integrated on the substrate 11, the sensor 300 has a high robustness and can be suitably used for the moving body that requires safety.

The optical circuits 100, 100A, 200, and 200A, the optical circuit devices 150A and 150B, or the sensor 300 according to the embodiments are not limited to the use for the gyro sensor, and can also be used for an acceleration sensor. When used for the acceleration sensor, the resonator 15 may be a WGM resonator that is supported like a cantilever and faces an upper surface of the first optical waveguide 131. The distance between the resonator 15 and the first optical waveguide 131 varies due to an inertial force caused by the acceleration, and the measured light intensity varies. In this state, the processor 305 in FIG. 12 calculates the acceleration from the variation in the signal intensity input from the electric circuit 50 and outputs the calculated acceleration.

### <Application Example>

For example, information terminals, such as smartphones, tablet terminals, watches, or the like, and moving bodies, such as drones, vehicles, ships, aircrafts, or the like can include the optical circuits 100, 100A, 200, and 200A, the optical circuit devices 150A and 150B, or the sensor 300 of the present disclosure. In the case of a drone, for example, a tilt of the fuselage can be controlled by providing a gyro sensor. Moreover, in the case of a vehicle, for example, the gyro sensor can form part of the driving support system.

FIG. 13 is a schematic diagram of a driving support system mounted on a moving body 500, such as a vehicle or the like. The driving support system illustrated in FIG. 13 includes an in-vehicle device 501 that is mounted in the vehicle and performs control related to driving support of the vehicle, a LiDAR 502, a gyro sensor 503, a vehicle body acceleration sensor 504, and a LiDAR acceleration sensor 505.

The in-vehicle device 501 is electrically connected to the LiDAR 502, the gyro sensor 503, the vehicle body acceleration sensor 504, and the LiDAR acceleration sensor 505, and acquires output therefrom. In addition, the in-vehicle device 501 includes a map database (DB) 510 that stores road data, feature information related to features provided near the roads, or the like. The in-vehicle device 501 estimates a vehicle position based on the output data and the map DB 510 described above, and performs control related to the driving support of the vehicle, such as automatic driving control or the like, based on the estimation result of the vehicle position.

The LiDAR 502 emits pulse laser light in predetermined angular ranges in the horizontal direction and the vertical direction to discretely measure distances to objects existing in the outside world, and supplies three dimensional point group information indicating the positions of the objects to the in-vehicle device 501. FIG. 13 illustrates an example in which the LiDAR 502 is provided in each of a front portion and a rear portion of the vehicle.

The gyro sensor 503 is provided in the vehicle, and supplies an output signal corresponding to a yaw rate of the vehicle body to the in-vehicle device 501. The gyro sensor 503 is the sensor 300 described in the embodiments according to the present disclosure. A plurality of gyro sensors 503 may be provided. For example, the gyro sensors 503 may be provided on each of the front wheel side and the rear wheel side of the vehicle, and each gyro sensor 503 may be electrically connected to the in-vehicle device 501. By using the plurality of gyro sensors 503, it is possible more accurately control the moving direction of the vehicle.

The vehicle body acceleration sensor 504 is an acceleration sensor provided in the vehicle, and supplies detection signals corresponding to three-axis acceleration data corresponding to the moving direction, the side direction, and the height direction of the vehicle body to the in-vehicle device 501. For example, the acceleration sensor corresponding to the height direction may detect a vibration of the vehicle and use the vibration for sensing a road surface condition. The LiDAR acceleration sensor 505 is a three-axis accelerometer provided in each LiDAR 502, and supplies detection signals corresponding to three-axis acceleration data of the LiDAR 502 to the in-vehicle device 501. The vehicle body acceleration sensor 504 and the LiDAR acceleration sensor 505 may be configured by the sensor 300 described in the embodiments according to the present disclosure.

Although the present invention is described above based on specific configuration examples, the present invention is not limited to the configuration examples described above. Electrodes may be provided in the vicinity of the optical couplers 31, 32, 33, and 34 or the first optical coupler 261 and the second optical coupler 262, and the phase of light, the branching ratio of modes, or the like may be finely adjusted by applying a voltage thereto. In this case, the electrodes may be formed of a good conductor having a high adhesion with respect to a base.

This application is based upon and claims priority to Japanese Patent Application No. 2021-211659, filed on December 24, 2021, the entire contents of which are incorporated herein by reference.

### DESCRIPTION OF THE REFERENCE NUMERALS

100, 100A, 200, 200A: optical circuit
11: substrate
15: resonator
20: laser light source
21: first annular optical waveguide
22: second annular optical waveguide
23: shared part
25: semiconductor layered structure
251: first semiconductor layer
252: active layer
253: second semiconductor layer
31: optical coupler (first branch)
32, 33, 34, 61, 62: optical coupler
35, 65: waveguide segment
41: first instrument
42: second instrument
43, 66: third instrument
45, 46: phase modulator
47: intensity modulator (light intensity control device)
50, 50A, 50B: electric circuit
51: signal source
52, 72: highpass filter
53, 73: mixer
55: controller
56, 58: phase shifter
57, 59: lowpass filter
67: intensity controller (light intensity control device)
131, 231: first optical waveguide
133, 134, 233, 234: optical waveguide
135, 232: second optical waveguide
150A, 150B: optical circuit device
261: first optical coupler
262: second optical coupler
300: sensor
305: processor
500: moving body

## Claims

1. An optical circuit comprising:
a substrate;
a laser light source formed on the substrate and including a first annular optical waveguide and a second annular optical waveguide that shares a part thereof with the first annular optical waveguide at one location;
a first optical waveguide located on the substrate at a position separated from the laser light source and optically coupled to the laser light source; and
a resonator optically coupled to the first optical waveguide.

2. The optical circuit as claimed in claim 1, wherein a ratio of a first area of a region surrounded by the first annular optical waveguide to a second area of a region surrounded by the second annular optical waveguide is between 0.5:1 and 2:1.

3. The optical circuit as claimed in claim 2, wherein the first area and the second area are equal to each other.

4. The optical circuit as claimed in any one of claims 1 to 3, wherein the first annular optical waveguide and the second annular optical waveguide are formed of a semiconductor layered structure including a first semiconductor layer including a first impurity of a first conductivity type, an active layer provided on the first semiconductor layer, and a second semiconductor layer provided on the active layer and including a second impurity of a second conductivity type.

5. The optical circuit as claimed in claim 4, wherein the laser light source and the first optical waveguide are parts of the semiconductor layered structure.

6. The optical circuit as claimed in any one of claims 1 to 5, further comprising:
a second optical waveguide disposed on the substrate so as to be optically coupled to the laser light source;
an instrument configured to measure an intensity of light guided through the second optical waveguide; and
an intensity controller configured to perform a feedback to the laser light source so that the intensity of the light measured by the instrument becomes constant,
wherein the second optical waveguide is disposed so that an optical coupling between the second optical waveguide and the laser light source is weaker than an optical coupling between the first optical waveguide and the laser light source.

7. The optical circuit as claimed in any one of claims 1 to 6, wherein the first optical waveguide is closest to one or both of the first annular optical waveguide and the second annular optical waveguide of the laser light source.

8. The optical circuit as claimed in any one of claims 1 to 7, wherein:
the first optical waveguide includes a first optical coupler optically coupled to the first annular optical waveguide, and a second optical coupler optically coupled to the second annular optical waveguide,
a ratio of a magnitude of optical coupling at the first optical coupler to a magnitude of optical coupling at the second optical coupler is between 0.8:1 and 1.2:1, and
the first optical waveguide forms an open waveguide segment between the first optical coupler and the second optical coupler.

9. The optical circuit as claimed in any one of claims 1 to 8, wherein:
the first optical waveguide includes a first branch configured to branch the light optically coupled to the laser light source at a ratio of 50:50,
the optical circuit includes a waveguide segment connected to the first branch, and
the resonator is optically coupled to the first optical waveguide at the waveguide segment.

10. The optical circuit as claimed in any one of claims 1 to 9, further comprising:
a phase modulator provided between the laser light source and the resonator,
wherein a frequency of the laser light source matches one of a first resonance frequency of light that passes through the phase modulator and circulates in the resonator in a clockwise direction and a second resonance frequency of light that passes through the phase modulator and circulates in the resonator in a counterclockwise direction.

11. An optical circuit device comprising:
the optical circuit according to any one of claims 1 to 10;
a first instrument configured to detect first output light of the light circulating in the resonator in a first direction;
a second instrument configured to detect second output light of the light circulating in the resonator in a second direction opposite to the first direction; and
an electric circuit configured to control the optical circuit based on signals measured by the first instrument and the second instrument.

12. A sensor comprising:
the optical circuit according to any one of claims 1 to 10 or the optical circuit device according to claim 11; and
a processor configured to process a measurement result of the output light of the optical circuit.

13. A moving body comprising:
the optical circuit according to any one of claims 1 to 10, or the optical circuit device according to claim 11, or the sensor according to claim 12.
